# EUROPEAN PATENT SPECIFICATION

(11) **EP 4 191 826 B1**
(45) Date of publication and mention of the grant of the patent: **27.05.2026**
(21) Application number: 21849980.4
(22) Date of filing: 28.07.2021
(51) Int. Cl.: H02J 50/00, H02J 50/12, H01F 38/14, H02J 50/40, H04B 5/00, H02J 7/00, G01R 31/382, H05K 7/20

(54) **WIRELESS POWER TRANSMISSION DEVICE**
VORRICHTUNG ZUR DRAHTLOSEN STROMÜBERTRAGUNG
DISPOSITIF DE TRANSMISSION D'ÉNERGIE SANS FIL

(30) Priority: 30.07.2020 KR 20200095536
(43) Date of publication of application: 07.06.2023
(73) Proprietor: Samsung Electronics Co., Ltd., Suwon-si, Gyeonggi-do 16677 (KR)
(72) Inventor: PARK, Jaehyun, Suwon-si Gyeonggi-do 16677 (KR); GU, Beomwoo, Suwon-si Gyeonggi-do 16677 (KR); PARK, Jaeseok, Suwon-si Gyeonggi-do 16677 (KR); YANG, Jihyun, Suwon-si Gyeonggi-do 16677 (KR); YEO, Sungku, Suwon-si Gyeonggi-do 16677 (KR); LEE, Jeongman, Suwon-si Gyeonggi-do 16677 (KR); LEE, Chongmin, Suwon-si Gyeonggi-do 16677 (KR)
(74) Representative: Gulde & Partner
(86) International application number: PCT/KR2021/009778
(87) International publication number: WO 2022/025617

(56) References cited:
- KR-A- 20100 112 034
- KR-A- 20150 037 904
- KR-A- 20170 020 143
- KR-A- 20200 032 576
- KR-A- 20200 083 114
- KR-A- 20200 083 114
- US-A1- 2015 008 753

## Description

### [Technical Field]

Various embodiments of the disclosure relate to a wireless power transmission device for wirelessly charging an electronic device.

### [Background Art]

Wireless charging technology uses wireless power transmission and reception, and refers to, for example, a technology by which the battery of a mobile phone can be automatically charged by simply placing the mobile phone on a wireless power transmission device (e.g., a charging pad) without connecting a separate charging connector. The wireless charging technology is advantageous in that an electronic product does not need to have a connector for power supply, thereby improving a waterproof function and that a wired charger is not required, thereby increasing the portability of an electronic device.

Recently, with the development of wireless charging technology, a method of charging by supplying power from one electronic device (a power transmitting unit) to various other electronic devices (a power receiving unit) is being studied. Wireless charging technology includes an electromagnetic induction method using a coil, a resonance method using resonance, and a RF/microwave radiation method that converts electrical energy into electromagnetic waves and transmits the same.

Recently, wireless charging technology using an electromagnetic induction method or a resonance method has been popularized in connection with an electronic device such as a smartphone. When a power transmitting unit (PTU) (e.g., a wireless power transmission device) and a power receiving unit (PRU) (e.g., a smartphone or a wearable electronic device) come into contact with each other or approach each other within a predetermined distance, the battery of the power receiving unit may be charged by a method such as electromagnetic induction or electromagnetic resonance between a transmitting coil of the power transmitting unit and a reception coil of the power receiving unit.

A method for transmitting power by using electromagnetic induction is a method for transmitting power by using the magnetic induction phenomenon between a primary coil and a secondary coil. When an alternating current flows through the primary coil, a time-varying magnetic field is generated around the primary coil, and an induced electromotive force is generated in the secondary coil of a reception terminal by the magnetic field, whereby power is transmitted. The electromagnetic induction method has excellent energy transfer efficiency, and thus has been the mainstream of wireless charging technology until now.

The following publications are related to wireless charging devices:
- KR 2020 0083114 A (WARP SOLUTION INC. [KR]) entitled "Supplementary battery for wire and wireless power transmission";
- US 2015/008753 A1 (PARK JAE HYUN [KR] ET AL) entitled "Wireless power transmission system including relay resonator and wireless power transmission method".

### [Detailed Description of the Invention]

### [Technical Problem]

The electromagnetic induction method is the most practical method and is being applied to various devices. The non-contact charging technology applied to conventional electric toothbrushes, razors, and smart devices employs the electromagnetic induction method. However, the wireless charging technology using the electromagnetic induction method may have the low charging efficiency when an electronic device is not placed in a predetermined position of a wireless power transmission device or is not placed to face a specific direction for charging. In addition, since the wireless charging technology by the electromagnetic induction method requires a short distance between a first coil and a second coil for power transmission and reception, the distance between an electronic device and a wireless power transmission device needs to be short.

In addition, when the electronic device corresponds to a wearable electronic device such as a watch, an earphone, or AR/VR glasses, in order to perform wireless charging using the electromagnetic induction method, the wireless power transmission device may have to include a wireless charging cradle having a shape corresponding to the shape of the electronic device to be charged.

In addition, in order for the wireless power transmission device to charge multiple electronic devices, primary coils as many as the electronic devices should be provided in the transmission device in order to charge the multiple electronic devices, and the multiple electronic devices may need to be placed in a designated region of the wireless power transmission device. An electronic device that is not placed in the designated area may remain uncharged until a user recognizes it.

Various embodiments of the disclosure by controlling the state of a wireless power transmission device wherein the wireless power transmission device charges multiple electronic devices, the entire 360 degrees around the wireless power transmission device can be covered, one primary coil can supply wireless power to the multiple electronic devices, and the electronic devices can be charged even when not placed in a designated area.

Various embodiments of the disclosure may provide a wireless power transmission device capable of charging an electronic device regardless of the position of the electronic device and the direction in which the electronic device is placed as long as the electronic device is within a designated distance around the wireless power transmission device.

Various embodiments of the disclosure may provide a wireless power transmission device including a resonator that can be mounted on the wireless power transmission device or in a predetermined position therearound and is used to extend the radius of transmission of wireless power.

### [Technical Solution]

The present invention is directed to subject matter as defined in the claims.

In particular, the invention is directed to a wireless power transmission device for wirelessly supplying power to at least one electronic device, the wireless power transmission device comprising a base housing, at least one resonator and a feeder wherein: the at least one resonator comprises a resonator housing configured to be coupled to one side of the base housing, at least one coil and at least one capacitor that is included in the resonator housing; and the feeder is disposed in the base housing, has a variable angle allowing tilting with respect to the resonator, comprises a coil and a capacitor coupled to the coil in series or in parallel, and is configured to generate an electromagnetic field to be coupled to the at least one resonator for transmitting wireless power to the electronic device.

### [Advantageous Effects]

Various embodiments may provide a wireless power transmission device capable of covering the entire 360 degrees around the wireless power transmission device when charging multiple electronic devices.

Various embodiments may provide a wireless power transmission device that provides a high degree of freedom without limitation on the charging position and charging direction of an electronic device.

Various embodiments may provide a wireless power transmission device capable of charging an electronic device even when the electronic device is not placed in a designated location if the electronic device is placed within a designated distance.

Various embodiments may provide a wireless power transmission device wherein a resonator separable from a base station is provided to allow the resonator to be disposed at a predetermined location, and the resonator can be used to extend a transmission radius.

According to various embodiments, various embodiments may provide a wireless power transmission device wherein a resonator separable from a base station is provided, thereby making it easy to package products compared to an integrated resonator.

### [Brief Description of Drawings]

FIG. 1A is a block diagram of an electronic device and a wireless power transmission device.
FIG. 1B is a block diagram of multiple electronic devices and a wireless power transmission device.
FIG. 2A illustrates an electronic device and a wireless power transmission device.
FIG. 2B is a detailed block diagram of a power transmission circuit and a power reception circuit.
FIG. 3 illustrates at least one electronic device and a wireless power transmission device.
FIG. 4 illustrates a wireless power transmission device.
FIG. 5 illustrates a base housing and a resonator of a wireless power transmission device.
FIG. 6 is a side cross-sectional view illustrating a wireless power transmission device in which a first resonator and a second resonator are mounted to a base housing according to various embodiments.
FIG. 7 is a cross-sectional view of a wireless power transmission device, seen from above, in which a first resonator and a second resonator are mounted to a base housing according to various embodiments.
FIG. 8 illustrates a feeder disposed between a first resonator and a second resonator and having a variable angle.
FIG. 9 illustrates an operation of charging multiple electronic devices by using a wireless power transmission device.
FIG. 10 is a flowchart illustrating a wireless charging operation of a wireless power transmission device.
FIG. 11 illustrates an embodiment in which the efficiency of wireless charging by a wireless power transmission device.

### [Mode for Carrying out the Invention]

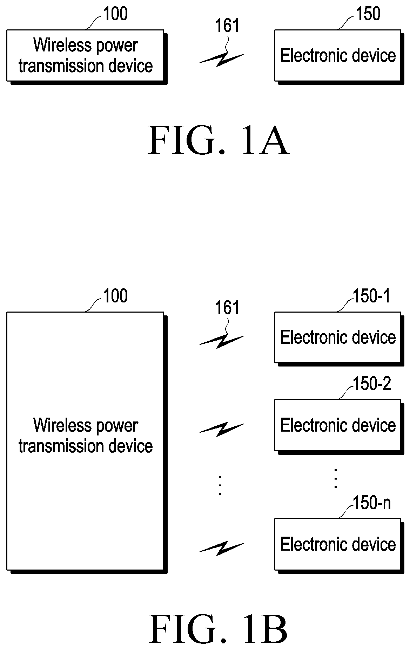

FIG. 1A is a block diagram of an electronic device and a wireless power transmission device. FIG. 1B is a block diagram of multiple electronic devices and a wireless power transmission device.

Referring to FIG. 1A, a wireless power transmission device 100 may wirelessly transmit power 161 to the wireless power reception device 150 (hereinafter, referred to as "electronic device 150"). The wireless power transmission device 100 may transmit the power 161 to the electronic device 150 by using various charging methods. For example, the wireless power transmission device 100 may transmit the power 161 according to an induction method. When the wireless power transmission device 100 uses an induction method, the wireless power transmission device 100 may include, for example, a power source, a DC-AC conversion circuit, an amplifier circuit, an impedance matching circuit, at least one capacitor, at least one coil, a communication modulation/demodulation circuit, etc. The at least one capacitor may constitute a resonant circuit together with the at least one coil. The wireless power transmission device 100 may be implemented in a manner defined in a wireless power consortium (WPC) standard (or Qi standard). In another example, the wireless power transmission device 100 may transmit the power 161 by using a resonance method. In the case of resonance method, the wireless power transmission device 100 may include, for example, a power source, a DC-AC conversion circuit, an amplifier circuit, an impedance matching circuit, at least one capacitor, at least one coil, an out-of-band short-range communication module (e.g., a Bluetooth low energy (BLE) short-range communication module), etc. The at least one capacitor and the at least one coil may constitute a resonant circuit. The wireless power transmission device 100 may be implemented in a manner defined in an Alliance for Wireless Power (A4WP) standard (or an air fuel alliance (AFA) standard). The wireless power transmission device 100 may include a coil capable of generating a time-varying magnetic field which has magnitude changing with time when an alternating current flows according to a resonance method or an induction method. The process in which the wireless power transmission device 100 generates a magnetic field may be expressed as a process in which the wireless power transmission device 100 outputs the power 161 or wirelessly transmits the power 161. In addition, the electronic device 150 may include a coil in which an induced electromotive force is generated by a magnetic field formed therearound and having magnitude changing with time. The process in which the electronic device 150 generates an induced electromotive force through a coil may be expressed as a process in which the power 161 is input into the electronic device 150 or in which the electronic device 150 wirelessly receives the power 161.

The wireless power transmission device 100 may communicate with the electronic device 150. For example, the wireless power transmission device 100 may communicate with the electronic device 150 in an in-band manner. The wireless power transmission device 100 or the electronic device 150 may change a load (or load impedance) of data to be transmitted, for example, depending on an on/off keying modulation scheme. The wireless power transmission device 100 or the electronic device 150 may determine data transmitted from a counterpart device by measuring a load change (or a load impedance change) based on a change in the magnitude of a current, a voltage, or power of the coil. In another example, the wireless power transmission device 100 may communicate with the electronic device 150 in an out-of-band manner. The wireless power transmission device 100 or the electronic device 150 may transmit and receive data by using a short-range communication module (e.g., a BLE communication module) provided separately from a coil or a patch antenna. The frequency band of wireless power and the band of the short-range communication module are spaced apart from each other. For example, in the case of the AirFuel standard, the frequency band of the wireless power is 6.78 MHz, and the frequency band of the short-range communication module is 2.4 GHz.

Herein, performing a specific operation by the wireless power transmission device 100 or the electronic device 150 may imply that various types of hardware included in the wireless power transmission device 100 or the electronic device 150, for example, a processor, a coil, or a patch antenna, performs the specific operation. Alternatively, performing a specific operation by the wireless power transmission device 100 or the electronic device 150 may imply that the processor controls another type of hardware to perform the specific operation. Alternatively, performing a specific operation by the wireless power transmission device 100 or the electronic device 150 may imply that the processor or another piece of hardware is caused to perform the specific operation by execution of an instruction stored in a storage circuit (e.g., a memory) of the wireless power transmission device 100 or the electronic device 150 so as to perform the specific operation.

As illustrated FIG. 1B, the wireless power transmission device 100 may wirelessly make an electrical connection with multiple electronic devices 150-1, 150-2, ..., 150-n. The multiple electronic devices may include, for example, a portable communication device (e.g., a smartphone), a wearable device (e.g., a watch, a wireless earphone, an AR/VR device), a portable multimedia device (e.g., a touchpad or a notebook computer), and a PDA, a PMP, a camera, a portable medical device, and a home appliance (e.g., a TV). Various other types of electronic devices may be applied.

The wireless power transmission device 100 may wirelessly transmit the power 161 to the multiple electronic devices 150-1, 150-2, ..., 150-n. For example, the wireless power transmission device 100 may transmit the power to the multiple electronic devices 150-1, 150-2, ..., 150-n through a resonance method. When the wireless power transmission device 100 adopts a resonance method, the distance between the wireless power transmission device 100 and each of the multiple electronic devices 150-1, 150-2, ..., 150-n, in which power can be transmitted and received, may be 50 cm or less, preferably 30 cm or less. For example, the wireless power transmission device 100 may transmit the power the multiple electronic devices 150-1, 150-2, ..., 150-n through an induction method. When the wireless power transmission device 100 adopts an induction method, the distance between the wireless power transmission device 100 and each of the multiple electronic devices 150-1, 150-2, ..., 150-n, in which power can be transmitted and received, may be 10 cm or less. It is possible that at least one of the multiple electronic devices 150-1,150-2, ..., 150-n may receive the power from the wireless power transmission device 100 through a resonance method, and at least any other one of the multiple electronic devices 150-1, 150-2, ..., 150-n may receive the power from the wireless power transmission device 100 through an induction method.

The processor included in the wireless power transmission device 100 may control predetermined power 161 to be transmitted to the multiple electronic devices 150-1,150-2, ...,150-n. For example, the predetermined power for the multiple electronic devices 150-1, 150-2, ..., 150-n may be power having a magnitude predetermined to driving (e.g., wake up) processors included in the multiple electronic devices 150-1, 150-2, ..., 150-n. The predetermined power 161 may be set in consideration of various types of information about the multiple electronic devices 150-1, 150-2, ..., 150-n (e.g., the various types of the electronic devices 150-1, 150-2, ..., 150-n, various pieces of required power information of the multiple electronic devices 150-1,150-2,...,150-n, voltage or current information related to various pieces of power of the multiple electronic devices 150-1,150-2,...,150-n, information about various ratings (e.g., effective values) of the multiple electronic devices 150-1, 150-2, ..., 150-n, and orientation information (e.g., posture information) of the multiple electronic devices 150-1, 150-2, ..., 150-n).

The wireless power transmission device 100 may communicate with each of the multiple electronic devices 150-1, 150-2, ..., 150-n simultaneously or sequentially and selectively or independently. Each of the multiple electronic devices 150-1, 150-2, ..., 150-n may transmit and receive data, which is to be transmitted, to and from the wireless power transmission device 100 in either an in-band manner or an out-of-band manner.

Here, the data may be data for controlling power reception of each of the multiple electronic devices. In addition, the data may include various pieces of information about the multiple electronic devices 150-1, 150-2, ..., 150-n.

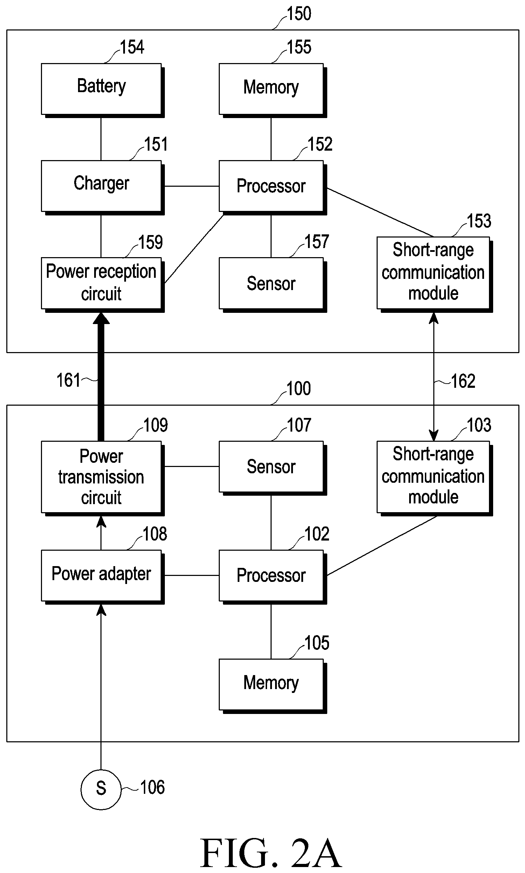

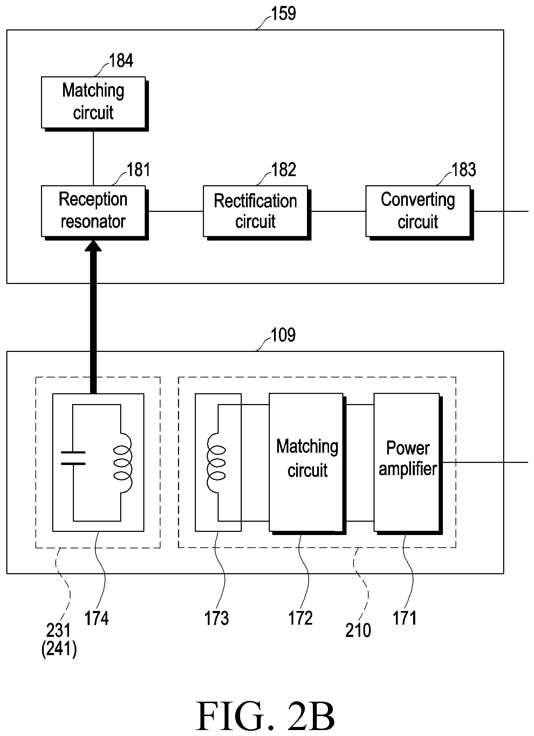

FIG. 2A illustrates an electronic device and a wireless power transmission device. FIG. 2B is a detailed block diagram of a power transmission circuit and a power reception circuit.

Referring to FIG. 2A, the wireless power transmission device 100 may include at least one of a processor 102, a short-range communication module 103, a memory 105, a power adapter 108, or a power transmission circuit 109. The electronic device 150 may include at least one of a charger 151, a processor 152, a short-range communication module 153, a battery 154, a memory 155, or a power reception circuit 159.

The power transmission circuit 109 may wirelessly transmit the power 161 by using at least one of an induction method, a resonance method, and an electromagnetic wave method. Detailed elements of the power transmission circuit 109 and the power reception circuit 159 will be described in more detail below with reference to FIG. 2B. The processor 102 may control overall operations of the wireless power transmission device 100. For example, the processor 102 may determine whether to transmit the power 161, may control the magnitude of the power 161, or may control at least one function (e.g., a charging start or a charging stop) of the electronic device 150. The processor 102 or the processor 152 may be implemented as various circuits capable of performing calculation, such as a general-purpose processor such as a CPU, a microprocessor, a micro controlling unit (MCU), and a field programmable gate array (FPGA), and the type thereof is not limited. The processor 102 may transmit and receive data to and from the electronic device 150 through the short-range communication module 103. Data can be used to control the transmission and reception of wireless power. The short-range communication module 103 and the short-range communication module 153 may be implemented as, for example, a short-range communication module of an out-of-band communication scheme (e.g., a Bluetooth communication module (BT or BLE), or an NFC communication module), or may be implemented as a load modulation communication module of an in-band communication scheme. In the case of the in-band communication scheme, the load modulation communication module may include, for example, a switch connected to a coil of the power reception circuit 159 directly or through another element, and a dummy load (e.g., a dummy resistor or a dummy capacitor) connected to the coil through another element or directly through the switch. The load modulation communication module may check information, based on a change in voltage or current applied to a coil in the power transmission circuit 109, which is detected during the on/off process of the switch. The power adapter 108 may receive power from a power source 106 and may provide the received power to the power transmission circuit 109. The power adapter 108 may be, for example, a power interface, and may not be included in the wireless power transmission device 100.

The power reception circuit 159 may wirelessly receive power from the power transmission circuit 109 by using at least one of an induction method, a resonance method, and an electromagnetic wave method. The power reception circuit 159 may perform power processing of rectifying the received AC waveform power into a DC waveform, converting a voltage, or regulating power. The charger 151 may charge the battery 154 by using received regulated power (e.g., DC power). The charger 151 may adjust at least one of a voltage or a current of the received power to transmit the power to the battery 154. The battery 154 may store the power and may transfer the power to another piece of hardware. Although not illustrated, a power management integrated circuit (PMIC) (not shown) may receive power from the power reception circuit 159 and transmit the power to another piece of hardware, or may receive power from the battery 154 and transmit the power to another piece of hardware. Also, the charger 151 may be included in the PMIC and provided.

The processor 152 may control overall operations of the electronic device 150. The memory 155 may store instructions for performing overall operations of the electronic device 150. The memory 105 may store instructions for performing the overall operation of the wireless power transmission device 100, or may store a lookup table of the relationship between information acquired through the short-range communication module 103 and the magnitude of power to be transmitted or mathematical expression information regarding the relationship between the acquired information and the magnitude of power to be transmitted. The memory 105 or the memory 155 may be implemented in various forms such as read only memory (ROM), random access memory (RAM), or flash memory, and there is no limitation on the implementation form.

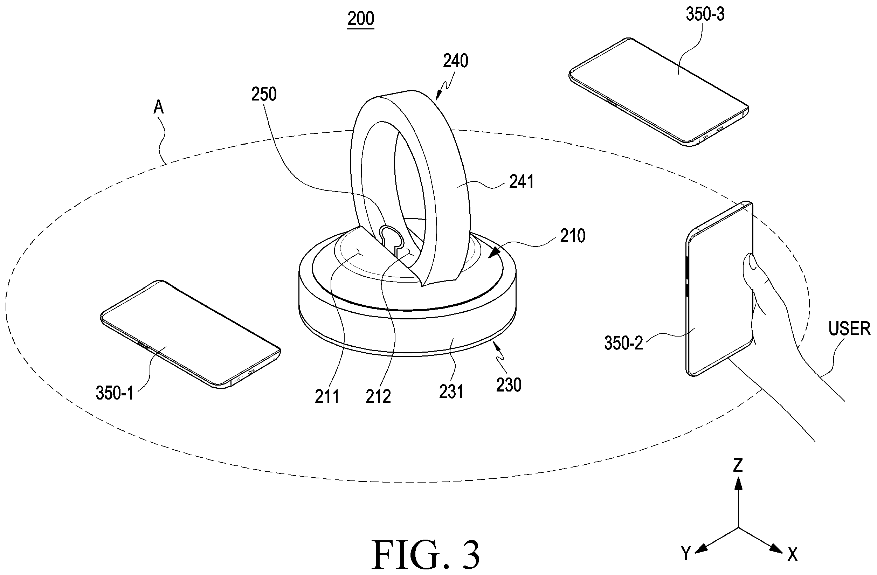

Referring to FIG. 2B, the power transmission circuit 109 may include a power amplifier 171, a matching circuit 172, a feeder 173, and a transmission resonator 174. The power amplifier 171 or an inverter circuit may convert DC power received from the power adapter 108 into AC power. The frequency of AC power may be set to 100 to 205 kHz or 6.78 MHz according to standards, but there is no limitation. The matching circuit 172 may change, under the control of the processor 102, at least one of capacitance or reactance of a circuit connected to the feeder 173, so that the power transmission circuit 109 and the power reception circuit 159 are impedance-matched with each other. The feeder 173 may be an element including at least one coil, and may supply power to the transmission resonator 174 through electromagnetic coupling with the coil of the transmission resonator 174. When AC power (or current) is applied to the transmission resonator 174, a magnetic field having a magnitude changing with time may be formed from the transmission resonator 174, and accordingly, power in the form of an electromagnetic field may be output or transmitted to the power reception circuit 159 of the electronic device 150. The transmission resonator 174 may include at least one coil and at least one capacitor. The feeder 173 may be disposed in a base housing 210, and the transmission resonator 174 may be disposed in a first resonator housing 231 or a second resonator housing 241 physically separable from the base housing 210. The physical configuration of the feeder 173 and the transmission resonator 174 will be described later in detail with reference to FIG. 3 and subsequent drawings below. In a reception resonator 181 of the power reception circuit 159, an induced electromotive force may be generated by a magnetic field formed therearound and having a magnitude changing with time, and accordingly, the power reception circuit 159 may wirelessly receive power. Although not shown in the drawing, the reception resonator 181 may include at least one coil and at least one capacitor. A rectification circuit 182 may rectify the received AC waveform power. A converting circuit 183 may adjust the voltage of the rectified power and transmit the power to the PMIC or the charger. The power reception circuit 159 may further include a regulator, or the converting circuit 183 may be replaced with a regulator. A matching circuit 184 may change, under control of the processor 152, at least one of capacitance or reactance of a circuit connected to the reception resonator 181 so that, the power transmission circuit 109 and the power reception circuit 159 are impedance-matched with each other.

Referring back to FIG. 2A, the wireless power transmission device 100 may include at least one sensor 107.

The at least one sensor 107 may be a sensor for measuring the voltage and current of the wireless power transmission device 200. The output impedance of the power amplifier 171, and/or the input impedance of the feeder 173 (e.g., the impedance of a signal input from the matching circuit 172 to the feeder 173), which will be described below, may be measured through the at least one sensor 107. For example, power consumption may be monitored by measuring a transmission voltage VTX_IN and a transmission current ITX_IN through the sensor 107, thereby detecting a change in the input impedance of the feeder 173. When the impedance change is detected, it is possible to determine whether the electronic device 150 that receives wireless power is placed/recovered, whether foreign matter is detected, and a change in the amount of power received. For example, while multiple electronic devices 150 are being charged in the wireless power transmission device 100, when one electronic device moves and thus the distance to the wireless power transmission device 100 decreases, the received power and efficiency of the other electronic devices may be reduced. In consideration of the detected impedance change, the processor 102 may control the transmission and efficiency of wireless power to the multiple electronic devices 150 according to a predetermined algorithm or a command input from a user.

The electronic device 150 may include at least one sensor 157.

For example, the electronic device 150 may detect the movement of the electronic device 150 by itself through the at least one sensor 157 (e.g., a motion sensor). The motion sensor for detecting the motion may include, for example, at least one of a gyro sensor, an acceleration sensor, an angular velocity sensor, a gravity sensor, a geomagnetic sensor, and an infrared sensor. However, the type of sensor is not limited thereto. In an example, the electronic device 150 may use the at least one sensor 157 to measure a voltage VRECT that is output from the rectification circuit 182. A change in the position relationship between the electronic device 150 and the wireless power transmission device 100 (whether the distance to the wireless power transmission device has been decreased or increased) may be determined based on the measured output voltage VRECT. Data detected by the sensor 157 may be provided to the processor 152, and the data received by the processor 152 may be provided to the wireless power transmission device 100 through the short-range communication module 153.

The processor 102 of the wireless power transmission device 100 may control the transmission and efficiency of wireless power to the multiple electronic devices 150 by using the data from the sensor 107 and/or the sensor 157. For example, one electronic device 150, among the multiple electronic device 150, may be placed around the wireless power transmission device 100 while being in a laid state. In addition, the electronic device 150 may be moved by the user and placed closer to the wireless power transmission device 100. At this time, the processor 102 of the wireless power transmission device 100 may determine that the electronic device 150 is in a laid state by using data detected from the sensor 107 and/or the sensor 157, and may determine that the electronic device 150 is close to the wireless power transmission device 100. Here, in order to use the data detected from the sensor 157 of the electronic device 150, the processor 102 may perform communication between the short-range communication module 103 of the wireless power transmission device 100 and the short-range communication module 153 of the electronic device 150 to acquire the data detected from the sensor 157. In addition, when the wireless power transmission device 100 includes multiple resonators, for example, a first resonator laid horizontally (e.g., a first resonator 230 that will be described later with reference to FIG. 3) and a second resonator stood vertically (e.g., a second resonator 240 that will be described later with reference to FIG. 3), the processor 102 may transmit power to the electronic device 150 by selecting and using the horizontally laid first resonator 230 based on information that the electronic device 150 is in a horizontally laid state.

FIG. 3 illustrates at least one electronic device and a wireless power transmission device.

Referring to FIG. 3, a wireless power transmission device 200 (e.g., the wireless power transmission device 100 of FIGS. 1A to 2A) includes a base housing 210 and at least one resonator 230 or 240. In addition, multiple electronic devices 350-1, 350-2, and 350-3 may be provided, and may be freely placed around the wireless power transmission device 200.

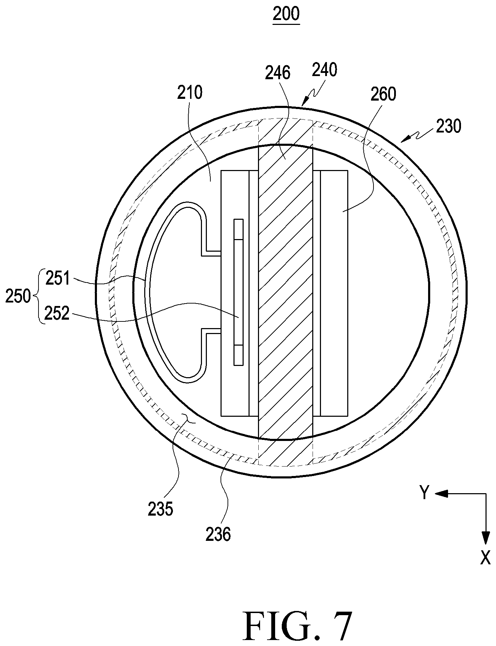

The coordinate axes illustrated in the drawings herein may be for indicating a direction faced by an element. Here, the coordinate axes may be coordinate axes (the X-axis, the Y-axis, and the Z-axis) in a three-dimensional space. Referring to FIG. 3, the X axis may be an axis parallel to the horizontal direction (or longitudinal direction) of the wireless power transmission device 200, and the Y axis may be an axis parallel to the vertical direction (or width direction) of the wireless power transmission device 200. The Z axis may be an axis parallel to the height direction of the wireless power transmission device 200. In addition, as will be described later, referring to FIG. 7 and subsequent drawings, when the wireless power transmission device 200 is viewed from above, the wireless power transmission device 200 may be placed on an imaginary plane including the X-axis and the Y-axis. The coupling relationship between each of elements may be described with reference to the various drawings disclosed herein and the coordinate axes included therein.

The base housing 210 is a part forming the exterior of the wireless power transmission device 200 together with at least one resonator housing 231 and 241. The inner space of the base housing 210 may accommodate various electronic components (e.g., at least one of the processor 102, the short-range communication module 103, the memory 105, the power adapter 108, the power amplifier 171, the matching circuit 172, and the feeder 173) included in the wireless power transmission device 200. The various electronic components may be integrated and accommodated in a system module (e.g., the system module 260 in FIG. 7) of the wireless power transmission device 200. The shape of the base housing 210 of the wireless power transmission device 200 is not limited to any of those herein disclosed. For example, in respect to FIG. 3, the base housing 210 may have an overall cylindrical shape, but is not necessarily limited thereto. Other possibilities, such as a polyhedron including a hexahedron, may be applied.

The wireless power transmission device 200 may include the resonators 230 and 240. The power transmission circuit 109 described above with reference to FIGS. 2A and 2B may include at least one coil and at least one capacitor, and may be implemented as including the resonators 230 and 240 surrounded by resonant housings. For example, the transmission resonator 174 disclosed in FIG. 2B may be implemented as the resonators 230 and 240 illustrated in FIG. 3

The resonators 230 and 240 may include at least one coil and at least one capacitor, may include a first resonator 230 surrounded by the first resonator housing 231, at least one coil, and at least one capacitor, and may include a second resonator 240 surrounded by the second resonator housing 241.

According to various embodiments, each of the resonators 230 and 240 is a ring-shaped resonator having a hollow portion (H) formed therein. The housings 231 and 241 of the first resonator 230 and the second resonator 240 may be formed to be identical to or different from each other in size, shape, inner configuration (e.g., inner configuration including at least one capacitor and at least one coil), etc.

The base housing 210 may have a structure allowing the first resonator housing 231 and the second resonator housing 241 to be placed thereon. Here, the first resonator housing 231 may be arranged to be placed on the base housing 210 in the horizontal direction, and the second resonator housing 241 may be arranged to be placed on the base housing 210 in the vertical direction. For example, the first resonator housing 231 may be coupled to the cylindrical outer circumferential edge of the base housing 210 while being in a laid state, and the second resonator housing 241 may be stood by being coupled to a groove 212 formed in the center of a top surface 211 of the base housing 210.

The first resonator 230 and the second resonator 240 may be formed interchangeably, and may thus be arranged interchangeably. For example, the second resonator housing 241 may be placed on the base housing 210 at a position in which the first resonator housing 231 is placed, and the first resonator housing 231 may be placed on the base housing 210 at a position in which the second resonator housing 241 is placed. Hereinafter, for convenience of description, the description will be made of a possibility in which the first resonator housing 231 is placed horizontal to the base housing 210 (or to the ground), and the second resonator housing 241 is placed perpendicular to the base housing 210 (or to the ground), but it should be noted that the disclosure is not limited thereto.

The first resonator 230 placed horizontal to the base housing 210 may be mainly coupled to electronic devices, placed on the floor near the wireless power transmission device 200, to transmit wireless power thereto. In addition, the second resonator 240 placed to perpendicular to the base housing 210 may be mainly coupled to electronic devices, stood near the wireless power transmission device 200 or spaced a predetermined distance apart from the floor in the height direction of the wireless power transmission device 200, to transmit wireless power thereto. However, the disclosure is not limited thereto. The first resonator 230 may be used to wirelessly transmit power to electronic devices stood near the wireless power transmission device 200 or spaced a predetermined distance apart from the floor, and the second resonator 240 may be used to transmit wireless power to electronic devices placed on the floor. However, it may be more advantageous in terms of transmission efficiency to charge electronic devices placed on the floor by using the first resonator 230 and to charge electronic devices stood or spaced a predetermined distance apart from the floor by using the second resonator 230.

According to FIG. 3, the first resonator housing 231 may be formed such that the entire portion (e.g., a circumferential portion) of the first resonator housing 231 is exposed to the outside of the base housing 210, but the second resonator housing 241 may be formed such that at least a portion thereof is inserted into the base housing 210 and the remaining portion thereof is exposed to the outside. The at least a portion of the second resonator housing 241 is inserted into the base housing 210, and thus the second resonator housing 241 can be stably placed. However, the shapes related to the base housing 210, the first resonator housing 231, and the second resonator housing 241 are not limited thereto, and may vary.

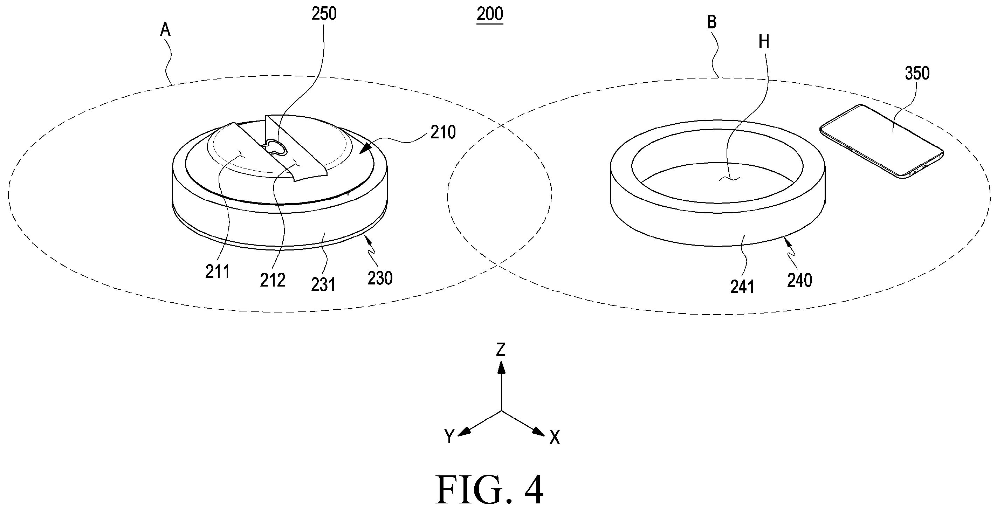

The first resonator housing 231 and the second resonator housing 241 may be detachably coupled to the base housing 210. As will be described later with reference to FIG. 4, any one of the first resonator housing 231 or the second resonator housing 241 may be spaced a predetermined distance apart from the base housing 210 of the wireless power transmission device 200, and the spaced resonator may be used as a repeater to extend the wireless power charging range of the wireless power transmission device 200.

Referring to FIG. 3, the wireless power transmission device 200 includes a feeder 250 (e.g., the feeder 173 in FIG. 2B) in the base housing 210.

The feeder 250 is electromagnetically coupled to the resonators 230 and 240 (e.g., the transmission resonator 174 in FIG. 2B), and the resonators 230 and 240 (e.g., the transmission resonator 174 of FIG. 2B), which have received power through the coupling with the feeder 250, output or transmit the power in the form of an electromagnetic field to electronic devices. For example, the feeder 250 may be disposed on one side of the base housing 210 to generate an electromagnetic field, and may simultaneously or selectively couple the generated electromagnetic field to the first resonator 230 and the second resonator 240. The feeder 250 may be configured by a series/parallel connection of a capacitor and a coil having a loop of at least one turn. According to various embodiments, the feeder 250 may be disposed in the base housing 210 but at least a portion of the feeder 250 may be exposed to the outside of the base housing 210.

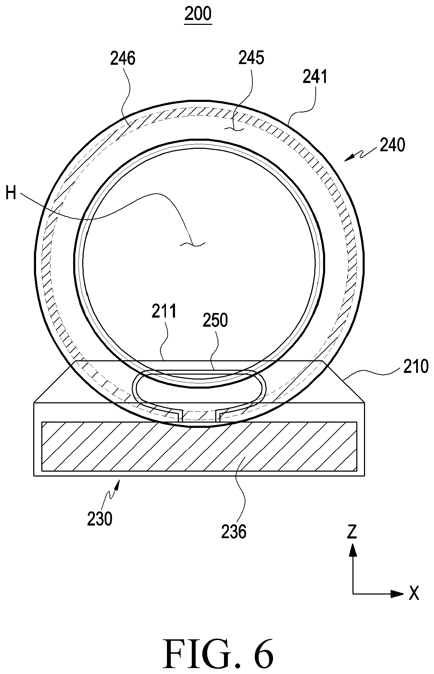

The feeder 250 is disposed at various angles at which coupling with the resonators 230 and 240 may occur, and multiple feeders 250 may be provided. In addition, a more detailed description of the feeder 250 will be made later through the embodiments illustrated in FIGS. 6 to 8 below.

A function of outputting or transmitting power to at least one electronic device 350-1, 350-2, or 350-3 may be performed using the wireless power transmission device 200 according to what has been described above.

The wireless power transmission device 200 may be used to provide, in addition to the power outputting or transmitting function, various display methods (e.g., LED light, sound, text message, voice, etc.) so that a user can intuitively recognize state-of-charge monitoring information of the at least one electronic device 350-1, 350-2, or 350-3.

Here, the state-of-charge monitoring information may include at least one of voltage information, current information, state-of-charge (SOC) information, and state-of-health (SOH) information about whether charging is possible or impossible. The power state of the electronic device may be determined through the voltage information or the current information. The power state may imply the amount of electrical energy remaining until the battery of the electronic device 350-1, 350-2, or 350-3 is discharged. For example, the power state may be expressed as a percentage such as 0%, 10%, 50%, or 100%. The state of charge (SOC) may indicate whether the electronic device 350-1, 350-2, or 350 - 3 is being charged or not. Information (SOH) on a state of whether the electronic device 350-1, 350-2, or 350-3 can be charged or not by using the wireless power transmission device 200 of the disclosure may also be displayed. The state-of-charge monitoring information is not limited thereto.

The wireless power transmission device 200 may acquire position information of the at least one electronic device 350-1, 350-2, or 350-3 placed at 360 degrees therearound. In order to acquire the position information, the above-described phased array coil may be used, or a UWB radar sensor may be used. Alternatively, the phased array coil and the UWB radar sensor may be used together to further increase the accuracy of position information. The state-of-charge monitoring information may be acquired through the short-range communication module 103 of the wireless power transmission device 200.

In relation to the at least one electronic device 350-1, 350-2, or 350-3 placed around the wireless power transmission device 200, a schematic flow of a power transmission method, a method of displaying position information, and a method for displaying information about the state of charge may be as follows. First, the wireless power transmission device 200 may transmit a load detection beacon and/or a power beacon, and may receive feedback of various pieces of information including voltage/power level information from the electronic device responding to the transmission of the beacon. Information fed back from the electronic device and information about the electronic device acquired through the short-range communication module 103 may be mapped to each other. A unique ID of the at least one electronic device 350-1, 350-2, or 350-3 may be identified using the short-range communication module 103 included in the wireless power transmission device 200. Furthermore, a pairing operation may be performed with respect to an electronic device having an authenticated ID. The wireless power transmission device 200 and the electronic device, which are paired with each other, may transmit and receive various pieces of data related to, for example, a power state and a charging state. Furthermore, position information of the at least one electronic device 350-1, 350-2, or 350-3 disposed around the wireless power transmission device 200 may be roughly acquired.

The wireless power transmission device 200 may adopt a resonance method (e.g., may apply the first resonator 230 and the second resonator 240 in FIG. 3) as a power transmission method for the at least one electronic device 350-1, 350-2, or 350-3 placed at 360 degrees around the wireless power transmission device 200. If the wireless power transmission device 200 is fixed at a certain position, power may be transmitted only when the electronic device 350-1, 350-2, or 350-3 is placed within a designated distance from the wireless power transmission device 200. For example, the effective distance for wireless power transmission between the wireless power transmission device 100 and the electronic device 350-1, 350-2, or 350-3 may be 50 cm or less, preferably 30 cm or less. FIG. 3 illustrates a first effective distance A as an example of the effective distance for wireless power transmission. According to FIG. 3, the first electronic device 350-1 and the second electronic device 350-2 are placed within an effective distance (e.g., the first effective distance A) for wireless power transmission, and thus a charging operation may be performed normally. In contrast, since the third electronic device 350- 3 is placed outside the effective distance, charging may not be performed or charging efficiency may be very low.

FIG. 4 illustrates an example of use of the wireless power transmission device 200 different from FIG. 3.

In FIG. 3, the first resonator housing 231 may be coupled to the outer circumferential edge of the base housing 210 in a horizontally laid state. Furthermore, the second resonator housing 241 may be stood upright in and coupled to the groove 212 formed in the center of the top surface 211 of the base housing 210.

On the other hand, referring to FIG. 4, the wireless power transmission device 200 may use one resonator (e.g., the second resonator 240) as a repeater for wireless power relay by taking advantage of the possible separation of the resonator housings 231 and 241 from the base housing 210.

With the first resonator housing 231 mounted on the base housing 210, the second resonator housing 241 may be placed in the space around the wireless power transmission device 200. At this time, the second resonator housing 241 may be placed in a direction horizontal to the ground at a location spaced a predetermined distance from the wireless power transmission device 200. In this arrangement, the output or transmission of wireless power by the wireless power transmission device 200 to the electronic device 350 may be implemented in a manner in which the first resonator 230 is coupled to the second resonator 240, and the second resonator 240 is coupled to an electronic device 350.

The first resonator 230 may be coupled to electronic devices placed on the floor near the wireless power transmission device 200 so as to transmit wireless power. At this time, the effective distance for wireless power transmission by the first resonator 230 of the wireless power transmission device 200 may be limited to a first effective distance A.

The second resonator 240 may be disposed at a location spaced a predetermined distance from the wireless power transmission device 200, thereby obtaining the effect of extending the effective distance for wireless power transmission by a second effective distance B of the second resonator 240. For example, the electronic device 350 illustrated in FIG. 4 is located outside the first effective distance A of the first resonator 230 but is located within the second effective distance B of the second resonator 240, and may thus receive power from the wireless power transmission device 200.

Although not illustrated in the drawing, even when the second resonator 240 is perpendicularly mounted on the wireless power transmission device 200 and when the first resonator 230 is placed at a location spaced a predetermined distance from the wireless power transmission device 200, the effect of extending an effective distance for transmission may be obtained.

The base housing 210 of the wireless power transmission device 200, and a separable resonator (e.g., the first resonator 230 and/or the second resonator 240) separable from the base housing 210 may be provided. Depending on a wireless charging environment desired by a user, the housing of the separable resonator (e.g., the first resonator housing 231 and/or the second resonator housing 241) may be coupled to the base housing 210 or placed at a predetermined location other than the base housing 210 to perform a wireless power charging function. Furthermore, an effective distance for wireless power transmission may be extended by appropriately arranging the separate resonator (e.g., the first resonator 230 and/or the second resonator 240).

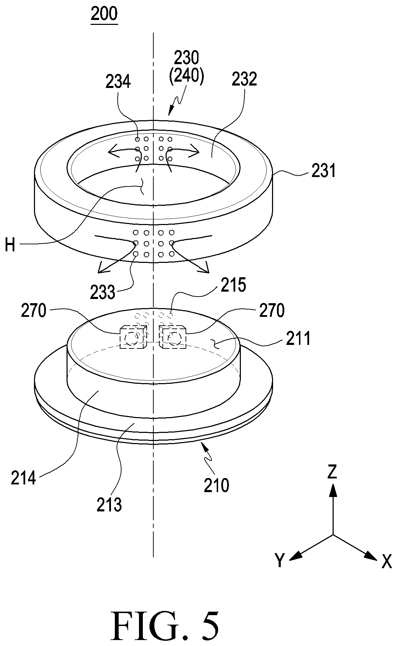

FIG. 5 illustrates the base housing 210 and the resonator housing 231 (or 241) of the wireless power transmission device 200, which are coupled to each other.

The following description of FIG. 5 is made of an example in which the first resonator housing 231 is used as a resonator housing coupled to the base housing 210, but may be applied equally or at least partially differently even when the second resonator housing 241 is coupled to the base housing 210.

For the stable placement of the first resonator housing 231 on the base housing 210, the base housing 210 may include an outer circumferential edge 214 corresponding to the hollow portion (H) of the first resonator housing 231 and a stepped portion 213 for supporting the bottom of the first resonator housing 231 when the housing 231 is laid.

Referring to FIG. 5, when the first resonator housing 231 is coupled to the base housing 210, the base housing 210 and the resonator housing 231 may be firmly coupled to each other by being fitted with a predetermined tolerance. According to FIG. 5, the outer circumferential edge 214 of the base housing 210 may have a height corresponding to the thickness of the resonator housing 231, but the disclosure is not necessarily limited thereto.

The wireless power transmission device 200 may include an air circulation structure for cooling the first resonator 230. In an example of the air circulation structure, the base housing 210 of the wireless power transmission device 200 may include at least one fan 270 and at least one outlet port 215 through which cool air discharged from the fan 270 is discharged. Furthermore, an inlet port 234 for suctioning cool air discharged from the fan 270 and an exhaust port 233 for discharging exhaust that is introduced from the inlet port 234 and flows in the first resonator housing 231 may be formed in the first resonator housing 231. For example, the exhaust port 233 may be formed in the outer circumferential edge of the first resonator housing 231, and the inlet port 234 may be formed in the inner circumferential edge of the first resonator housing 231 at a position corresponding to the outlet port 215 of the base housing 210. As illustrated in FIG. 5, the cool air discharged from the fan 270 may be introduced into the first resonator housing 231 through the inlet port 234, may flow clockwise and/or counterclockwise in the first resonator housing 231 to dissipate the heat of the first resonator 230, and may be discharged out of the first resonator housing 231.

The fan 270, the number and location of each of the outlet port 215, the inlet port 234, and the exhaust port 233 may be variously configured according to the embodiments. Although not illustrated in the drawings, the cool air flowing in the first resonator housing 231 may flow in various ways depending on the positions of the inlet port 234 and the exhaust port 233 to discharge heat generated in the resonator.

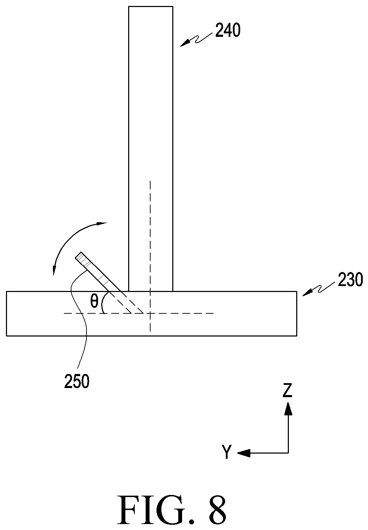

FIG. 6 is a side cross-sectional view illustrating a wireless power transmission device 200 in which a first resonator 230 and a second resonator 240 are mounted to a base housing 210 according to various embodiments. FIG. 7 is a cross-sectional view of the wireless power transmission device 200, seen from above, in which the first resonator 230 and the second resonator 240 are mounted to the base housing 210 according to various embodiments. FIG. 8 illustrates a feeder 250 disposed between the first resonator 230 and the second resonator 240 and having a variable angle.

The inner structure of the wireless power transmission device 200 will be described with reference to FIGS. 6 and 7 together. The drawings illustrate the first resonator 230 arranged horizontal to the base housing 210 and the second resonator 240 arranged perpendicular to the base housing 210. A space 245 for the flow of cool air may be formed in the second resonator housing 241, and a second coil 246 wound with at least one turn may be included in the space 245. The first resonator 230 may have substantially the same configuration as the second resonator 240, and thus a first coil 236 wound with at least one turn may be included in the first resonator housing 231.

In a position adjacent to the first resonator 230 and the second resonator 240, the feeder 250 having the form of a loop may be disposed. The feeder 250 may be electromagnetically coupled to the first resonator 230 and the second resonator 250. The first resonator 230 and the second resonator 240, which have received power through coupling with the feeder 250, may output or transmit wireless power in the form of an electromagnetic field to electronic devices.

According to various embodiments, the wireless power transmission device 200 may include multiple feeders 250. For example, the feeders 250 may include a first feeder 251, which faces the first resonator 230 and generates an electromagnetic field in the first resonator 230, and a second feeder 252, which faces the second resonator 240 and generates an electromagnetic field in the second resonator 240. The first feeder 251 and the second feeder 252 may extend from the inside of the base housing 210 while facing different directions. Here, the fact that one feeder faces one resonator may imply that the one feeder is positioned closer to or tilted closer to the one resonator to be coupled than the other feeder. For example, the fact that the first feeder 251 faces the first resonator 230 may imply that the first feeder 251 is positioned closer to the first resonator 230 than the second feeder 252 is positioned to the first resonator 230, or that the tilting of the first feeder 251 to the first resonator 230 is greater than the tilting of the second feeder 252 to the first resonator 230.

According to an embodiment, the first feeder 251 and the second feeder 252 may be connected to a system module 260 disposed in the base housing 210. The system module 260 may be accommodated in the base housing 210, and according to an embodiment, may not be exposed to the outside of the base housing 210. The first feeder 251 and the second feeder 252 may be electrically connected to the power amplifier 171 and/or the matching circuit 172 in the system module 260, respectively. Accordingly, the first feeder 251 and the second feeder 252 may be simultaneously or selectively fed with power by the processor 102 based on, for example, the posture information of an electronic device placed around the wireless power transmission device 200, to generate electromagnetic fields in the first resonator 230 and the second resonator 240.

Referring to FIG. 8, the first resonator 230 and the second resonator 240 may be simultaneously or selectively coupled to one feeder 250 to generate electromagnetic fields. For example, the first resonator 230 and the second resonator 240 may be coupled simultaneously to one feeder 250, and each of the first resonator 230 and the second resonator 240 simultaneously coupled to one the feeder 250 may output or transmit power in the form of an electromagnetic field.

According to the present invention, and as shown in FIG. 8, the feeder 250 must have a variable angle θ in a space formed between the first resonator housing 231 and the second resonator housing 241. When the angle of the feeder 250 with respect to the first resonator housing 231 and/or the second resonator housing 241 is varied, the first resonator 230 and the second resonator 240 may be respectively coupled with the feeder 250 to output or transmit, to the outside, power having different magnitudes. For example, when the feeder 250 is tilted closer to the first resonator housing 231 among the first resonator housing 231 and the second resonator housing 241, the magnitude of power output or transmitted from the first resonator 230 may be greater than the magnitude of power from the second resonator 240. Here, the fact that the feeder is tilted closer to a certain resonator housing may imply that the angle between the feeder and the certain resonator housing becomes smaller.

According to an embodiment, the feeder 250 may be selectively coupled to any one of the first resonator 230 and the second resonator 240 by changing the angle of the feeder 250.

According to various embodiments, the target fed with power by the feeder 250 may be variously applied according to the environment around the wireless power transmission device 200. For example, when there is an electronic device (e.g., the electronic device 350-1 in FIG. 3) placed on the ground around the wireless power transmission device 200, the angle θ which the feeder 250 forms with respect to the first resonator housing 231 may be small. At this time, the first coil 236 of the first resonator 230 and the feeder 250 may be disposed adjacent to each other, and the coupling efficiency between the first coil 236 and the feeder 250 may be increased. In another example, when there is an electronic device (e.g., the electronic device 350-2 of FIG. 3) placed at a predetermined height from the ground around the wireless power transmission device 200, the angle (θ) formed by the feeder 250 with respect to the first resonator 230 may be large so that the feeder 250 and the coil 246 of the second resonator 240 may be adjacent to each other.

According to an embodiment, when the first resonator 230 and the second resonator 240 share one feeder 250, the feeder 250 may have an optimal angle at which the efficiency of power transmitted to an electronic device is good. In this case, the feeder 250 may be coupled to one resonator as a main resonator, and may be coupled to the other resonator as a sub resonator. For example, the feeder 250 may be coupled to the first resonator 230 allocated as a main resonator, and may be coupled to the second resonator 240 allocated as a sub-resonator.

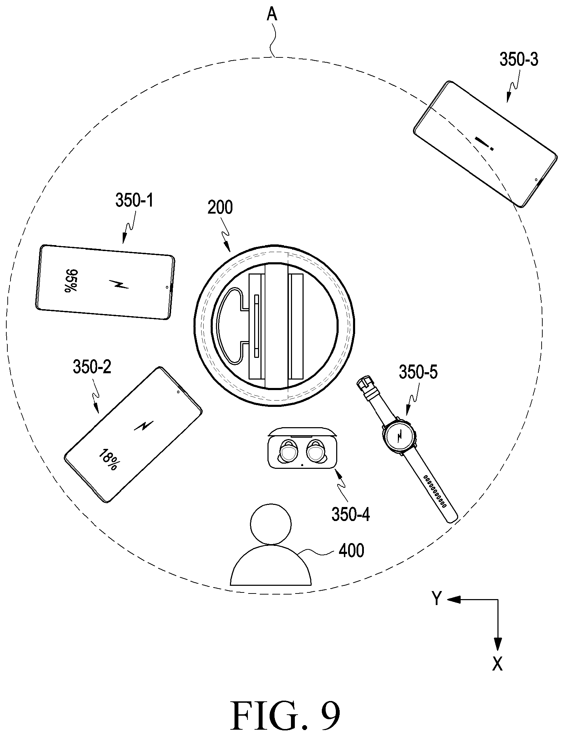

FIG. 9 illustrates an operation of charging multiple electronic devices by using the wireless power transmission device 200.

The above-mentioned wireless power transmission device 200 in FIGS. 1 to 6 may be used to perform a function of transmitting power to at least one electronic device 350-1, 350-2, 350-3, 350-4, or 350-5.

The wireless power transmission device 200 may be used to provide, in addition to the power transmission function, various display methods so that a user can intuitively recognize state-of-charge monitoring information of the at least one electronic device 350-1, 350-2, 350-3, 350-4, or 350-5. For example, in order to display the state-of-charge monitoring information, a display unit may be provided on one surface of the base housing 210, or a light-emitting module may be provided. In another example, in order to display the state-of-charge monitoring information, an electronic device (e.g., 350-1) having a display unit (e.g., a display) may be used.

Referring to FIG. 9, multiple electronic devices 350-1, 350-2, 350-3, 350-4, and 350-5 may be placed on an imaginary plane, defined by the X-axis and Y-axis, around the wireless power transmission device 200. The first electronic device 350-1 thereof may be placed at the upper left side of the wireless power transmission device 200 when the wireless power transmission device 200 is viewed from above, and the power state of the first electronic device 350-1 may correspond to 95%. The second electronic device 350-2 may be placed at the lower left side of the wireless power transmission device 200 when the wireless power transmission device 200 is viewed from above, and the power state of the second electronic device 350-2 may correspond to 18%. The third electronic device 350-3 may be placed at the upper right side of the wireless power transmission device 200 when the wireless power transmission device 200 is viewed from above. At this time, the third electronic device 350-2 may be placed beyond the effective distance A for wireless power transmission between the wireless power transmission device 100 and each of the electronic devices 350-1, 350-2, 350-3, 350-4, and 350-5, and thus the charging efficiency may be reduced or charging may not be performed. The fourth electronic device 350-4 may be placed below the wireless power transmission device 200 when the wireless power transmission device 200 is viewed from above, and the power state of the fourth electronic device 350-4 may correspond to 70%. The fifth electronic device 350-5 may be placed at the lower right side of the wireless power transmission device 200 when the wireless power transmission device 200 is viewed from above, and the power state of the fifth electronic device 350-5 may correspond to 100%. In the above-described example, the wireless power transmission device 200 may transmit wireless power to the first electronic device 350-1, the second electronic device 350-2, and the fourth electronic device 350-4.

For example, the first electronic device 350-1 and the second electronic device 350-2 may correspond to electronic devices that consume a large amount of power for the same time, such as a smart phone including a display, and the fourth electronic device 350-4 may correspond to a wearable electronic device that consumes a relatively small amount of power. In FIG. 9, the first electronic device 350-1 and the second electronic device 350-2 may be in a state of being laid on the ground. In contrast, the fourth electronic device 350-2 may be stood perpendicular to the ground or held by a user 400, and may be spaced apart from the ground by a predetermined distance.

The wireless power transmission device 200 may use the processor 102 to adjust the power transmission efficiency, based on the type of electronic device placed nearby, the state of charge of the electronic device, the distance between the electronic device and the wireless power transmission device 200, whether or not the electronic device placed nearby are mounted/recovered, whether foreign matter is detected, or a change in the amount of power received.

For example, when the first electronic device 350-1, among the multiple electronic devices 350-1, 350-2, 350-3, 350-4, and 350-5 placed around the wireless power transmission device 200, is placed closest to the wireless power transmission device 200, the wireless power transmission device 200 may configure the amount of power supplied to the first resonator 230, disposed horizontal to the base housing 210 of the wireless power transmission device 200, to be greater than the amount of power supplied to the second resonator 240, in order to increase the efficiency of transmission of power to the first electronic device 350-1.

In another example, the second electronic device 350-2, among the multiple electronic devices 350-1, 350-2, 350-3, 350-4, and 350-5 placed around the wireless power transmission device 200, has the lowest charging efficiency, and thus, in order to increase the efficiency of transmission of power to the second electronic device 350-2, the wireless power transmission device 200 may configure the amount of power supplied to the first resonator 230, disposed horizontal to the base housing 210 of the wireless power transmission device 200, to be greater than the amount of power supplied to the second resonator 240.

In another example, in order to increase the charging efficiency of the fourth electronic device 350-4, the wireless power transmission device 200 may configure the amount of power supplied to the second resonator 240, disposed perpendicular to the base housing 210 of the wireless power transmission device 200, to be greater than the amount of power supplied to the first resonator 230.

A method of adjusting the power transmission efficiency of the wireless power transmission device 200 of the disclosure may vary from what has been described above.

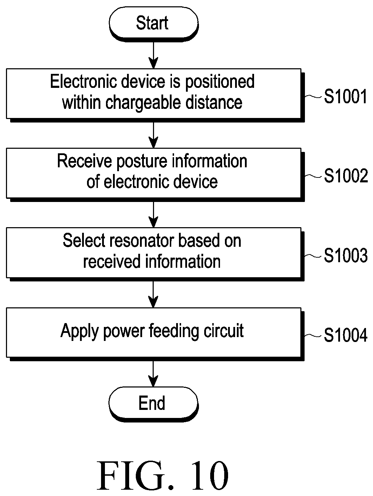

FIG. 10 is a flowchart illustrating a wireless charging operation of the wireless power transmission device 200 based on posture information of an electronic device.

Referring to FIG. 10, in operation S1001, it may be determined, through a short-range communication module 103 or at least one sensor 110 of the wireless power transmission device 200, that an electronic device is positioned within a chargeable distance.

When the electronic device is positioned within the chargeable effective range (A) of the wireless power transmission device 200, the wireless power transmission device 200 may receive, from the electronic device, various pieces of information (e.g., various types of electronic devices, various pieces of required power information of multiple electronic devices, voltage or current information related to various pieces of power of the multiple electronic devices, various pieces of rating (e.g., effective value) information of the multiple electronic devices, and orientation information (e.g., posture information) of the multiple electronic devices). In relation to operation S1002, FIG. 4 illustrates that the wireless power transmission device 200 receives motion information (posture information) of the electronic device.

In relation operation S1003, when the wireless power transmission device 200 includes multiple resonators, for example, the first resonator 230 laid horizontally and the second resonator 240 stood vertically, a resonator suitable for power transmission may be selected according to posture information of the electronic device to couple wireless power through a feeder.

In relation to operation S1004, in order to form an electromagnetic field in the selected resonator, AC power (or current) may be applied to a feeder 250 oriented toward the resonator.

When one electronic device is positioned around the wireless power transmission device 200, the wireless power transmission device 200 may perform a charging operation for the one electronic device provided that the one electronic device can receive power.

In contrast, when multiple electronic devices are placed around the wireless power transmission device 200, power may be transmitted to the multiple electronic devices according to a charging priority based on a predetermined algorithm. The processor 102 may control the power transmission circuit 172 to transmit power to the multiple electronic devices according to the charging priority based on the predetermined algorithm.

The wireless power transmission device 200 may determine by itself a charging priority of the multiple electronic devices according to a preset algorithm, based on state-of-charge information of the multiple electronic devices. In addition, power may be distributed to the electronic devices according to the determined priority.

For example, a high priority may be given to an electronic device in a low-power state. For example, a high priority may be given to an electronic device consuming a large amount of power. For example, when the power states of the multiple electronic devices are equal to each other, power may be equally distributed and transmitted. For example, a high priority may be given to an electronic device currently being used by the user. For example, a high priority may be given to an electronic device that is close to the wireless power transmission device 200.

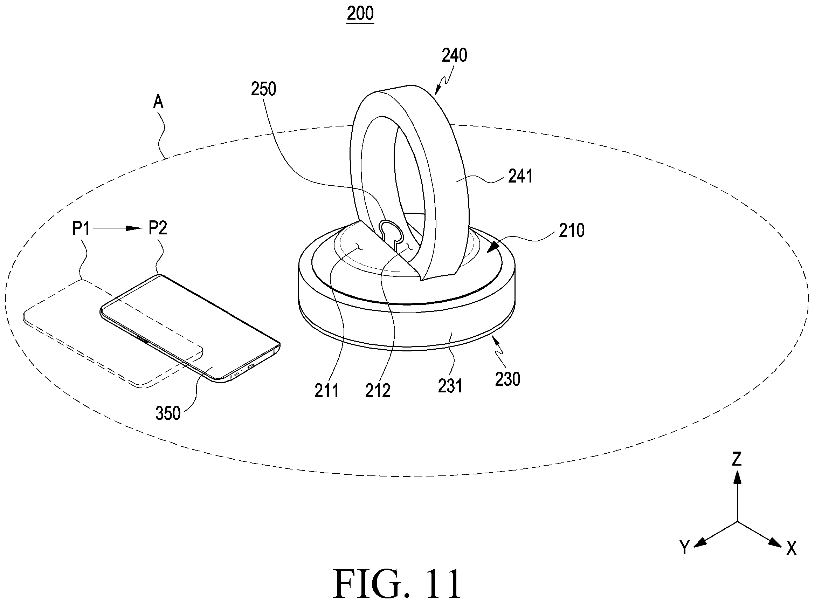

FIG. 11 illustrated a case in which wireless charging efficiency is increased when an electronic device approaches the vicinity of the wireless power transmission device 200.

Referring to FIG. 11, it is illustrated that an electronic device 350 is placed around the wireless power transmission device 200. For example, the electronic device 350 may be placed around the wireless power transmission device 100 while being in a laid state. In addition, the electronic device 350 may be moved by a user and placed closer to the wireless power transmission device 100. For example, the electronic device 350 may be moved from a location P1 to a location P2. In this case, the processor 102 of the wireless power transmission device 200 may determine that the electronic device 350 is in a laid state by using data detected from the sensor 107 and/or the sensor 157, and that the electronic device 350 is close to the wireless power transmission device 200. Furthermore, when an algorithm for transmitting greater power when the electronic device 350 approaches the wireless power transmission device 200 is predetermined, the processor 102 may increase the magnitude of power applied to the coil 173 to transmit greater power to the electronic device 350. Here, the processor 102 may transmit power to the electronic device 350 by supplying power to the horizontally laid first resonator 230.

The electronic device according to various embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. The electronic device according to embodiments of the disclosure is not limited to those described above.

With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C" may include all possible combinations of the items enumerated together in a corresponding one of the phrases. As used herein, such terms as "a first", "a second", "the first", and "the second" may be used to simply distinguish a corresponding element from another, and does not limit the elements in other aspect (e.g., importance or order). It is to be understood that if an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used herein, the term "module" may include a unit implemented in hardware, software, or firmware, and may be interchangeably used with other terms, for example, "logic," "logic block," "component," or "circuit". The "module" may be a minimum unit of a single integrated component adapted to perform one or more functions, or a part thereof. For example, the "module" may be implemented in the form of an application-specific integrated circuit (ASIC).

Various processes as set forth herein may be implemented as software (e.g., the program 840) including one or more instructions that are stored in a storage medium (e.g., the internal memory 836 or external memory 838) that is readable by a machine (e.g., the electronic device 801). For example, a processor (e.g., the processor 820) of the machine (e.g., the electronic device 801) may invoke at least one of the one or more stored instructions from the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

Various processes of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each element (e.g., a module or a program) of the above-described elements may include a single entity or multiple entities. One or more of the above-described elements may be omitted, except for any of those comprised in the subject-matter of appended claim 1, or one or more other elements may be added. Alternatively or additionally, a plurality of elements (e.g., modules or programs) may be integrated into a single element. In such a case, the integrated element may still perform one or more functions of each of the plurality of elements in the same or similar manner as they are performed by a corresponding one of the plurality of elements before the Operations performed by the module, the program, or another element may be carried out sequentially, in parallel, repeatedly, or heuristically, or one or more of the operations may be executed in a different order or omitted, or one or more other operations may be added.

The present disclosure provides a main embodiment of a wireless power transmission device for wirelessly supplying power to at least one electronic device, the wireless power transmission device comprising a base housing, at least one resonator and a feeder wherein: the at least one resonator comprises a resonator housing configured to be coupled to one side of the base housing, at least one coil and at least one capacitor that is included in the resonator housing; and the feeder is disposed in the base housing, has a variable angle allowing tilting with respect to the resonator, comprises a coil and a capacitor coupled to the coil in series or in parallel, and is configured to generate an electromagnetic field to be coupled to the at least one resonator for transmitting wireless power to the electronic device. Preferred embodiments of said main embodiment include the embodiments described below:

According to various embodiments, the at least one resonator may be configured to be detachably coupled to the base housing.

According to various embodiments, the at least one resonator may be a ring-shaped resonator in which a hollow portion is formed.

According to various embodiments, the at least one resonator may include a first resonator including a first resonator housing configured to be coupled to one side of the base housing, at least one coil and at least one capacitor being included in the first resonator housing, and a second resonator including a second resonator housing configured to be coupled to one side of the base housing, at least one coil and at least one capacitor being included in the second resonator housing.

According to various embodiments, the base housing may include an outer circumferential edge corresponding to a hollow portion of the first resonator housing, when the first resonator housing is seated, and a stepped portion configured to support the first resonator housing.

According to various embodiments, a groove to, which the second resonator housing is configured to be coupled, may be formed in a top surface of the base housing.

According to various embodiments, the first resonator housing may be configured to be coupled to the base housing in a direction horizontal to the ground, and the second resonator housing may be configured to be coupled to the base housing in a direction perpendicular to the first resonator housing.

According to various embodiments, the feeder may include: a first feeder configured to generate an electromagnetic field in the first resonator; and a second feeder configured to generate an electromagnetic field in the second resonator.

According to various embodiments, the variable angle depends on posture information of an electronic device placed around the wireless power transmission device.

According to various embodiments, at least one fan may be accommodated in the inner space of the base housing, and at least one outlet port through which cool air discharged from the fan is discharged may be formed in the outer circumferential edge of the base housing.

According to various embodiments, the resonator housing may have an inlet port configured to suction cool air discharged from the fan, and an exhaust port configured to discharge exhaust air introduced from the inlet port and flowing in the resonator housing.

According to various embodiments, the wireless power transmission device may further include at least one sensor configured to measure a transmission voltage or a transmission current of the at least one resonator.

According to various embodiments, the processor may control the power transmission circuit to adjust the efficiency of power transmitted to the electronic device according to a predetermined algorithm.

According to various embodiments, when multiple electronic devices are placed around the wireless power transmission device, the processor may control the power transmission circuit to transmit power according to a charging priority of the multiple electronic devices based on a predetermined algorithm.

## Claims

1. A wireless power transmission device (100, 200) for wirelessly supplying power (161) to at least one electronic device (150, 350-1), the wireless power transmission device (100, 200) comprising:
a base housing (210);
at least one resonator (230, 240) comprising a resonator housing (231, 241) configured to be coupled to one side of the base housing (210), at least one coil and at least one capacitor being included in the resonator housing (231, 241); and
a feeder (250) disposed in the base housing (210), comprising a coil and a capacitor coupled to the coil in series or in parallel, and configured to generate an electromagnetic field to be coupled to the at least one resonator (230, 240) for transmitting wireless power (161) to the electronic device (150, 350-1),
the wireless power transmission device (100,200) being **characterized in that**
the feeder (250) has a variable angle allowing tilting with respect to the resonator (230, 240).

2. The wireless power transmission device (100, 200) of claim 1, wherein the at least one resonator (230, 240) is configured to be detachably coupled to the base housing (210).

3. The wireless power transmission device (100, 200) of claim 1 or 2, wherein the at least one resonator (230, 240) is a ring-shaped resonator (230, 240) in which a hollow portion is formed.

4. The wireless power transmission device (100, 200) of any of claims 1 to 3, wherein the at least one resonator (230, 240) comprises:
a first resonator (230) comprising a first resonator housing (231) configured to be coupled to one side of the base housing (210), at least one coil and at least one capacitor being included in the first resonator housing (231), and,
a second resonator (240) comprising a second resonator housing (241) configured to be coupled to one side of the base housing (210), at least one coil and at least one capacitor being included in the second resonator housing (241).

5. The wireless power transmission device (100, 200) of claim 4, wherein the base housing (210) comprises an outer circumferential edge (214) corresponding to a hollow portion of the first resonator housing (231), when the first resonator housing (231) is seated, and a stepped portion (213) configured to support the first resonator housing (231).

6. The wireless power transmission device (100, 200) of claim 4, wherein a groove (212), to which the second resonator housing (241) is configured to be coupled, is formed in a top surface (211) of the base housing (210).

7. The wireless power transmission device (100, 200) of claim 4, wherein the first resonator housing (231) is configured to be coupled to the base housing (210) in a direction horizontal to the ground, and
the second resonator housing (241) is configured to be coupled to the base housing (210) in a direction perpendicular to the first resonator housing (231).

8. The wireless power transmission device (100, 200) of claim 4, wherein the feeder (250) comprises:
a first feeder (251) configured to generate an electromagnetic field in the first resonator (230); and
a second feeder (252) configured to generate an electromagnetic field in the second resonator (240)

9. The wireless power transmission device (100, 200) of any of claims 1 to 8, wherein the feeder (250) has an angle varying with respect to the resonator (230, 240) depending on posture information of an electronic device (150, 350-1) placed around the wireless power transmission device (100, 200).

10. The wireless power transmission device (100, 200) of any of claims 1 to 3, wherein at least one fan (270) is accommodated in an inner space (245) of the base housing (210), and at least one outlet port (215) through which cool air discharged from the fan (270) is discharged is formed in the outer circumferential edge (214) of the base housing (210), and
the resonator housing (231, 241) has an inlet port (234) configured to suction cool air discharged from the fan (270), and an exhaust port (233) configured to discharge exhaust air introduced from the inlet port (234) and flowing in the resonator housing (231, 241).

11. The wireless power transmission device (100, 200) of any of claims 1 to 10, further comprising at least one sensor (107, 157) configured to measure a transmission voltage or a transmission current of the at least one resonator (230, 240).

12. The wireless power transmission device (100, 200) of any of claims 1 to 11, comprising a processor (102, 152, 820) configured to control whether the feeder (250) supplies power (161) to the first resonator (230) or the second resonator (240) according to state-of-charge monitoring information of an electronic device (150, 350-1) around the wireless power transmission device (100, 200) and posture information of the electronic device (150, 350-1).

13. The wireless power transmission device (100, 200) of claim 12, wherein the processor (102, 152, 820) is configured to control the power transmission circuit (109) to adjust efficiency of power (161) transmitted to the electronic device (150, 350-1).

14. The wireless power transmission device (100, 200) of claim 12, wherein the processor (102, 152, 820) is configured to control, when multiple electronic devices (150, 350-1) are placed around the wireless power transmission device (100, 200), the power transmission circuit (109) to transmit power (161) according to a charging priority of the multiple electronic devices (150, 350-1).

15. The wireless power transmission device of claim 12, wherein the state-of-charge monitoring information comprises at least one of voltage information, current information, a state of charge, SOC, or a state of health, SOH

## Patentansprüche

1. Drahtlose Energieübertragungsvorrichtung (100, 200) zur drahtlosen Energieversorgung (161) von mindestens einer elektronischen Vorrichtung (150, 350-1), wobei die drahtlose Energieübertragungsvorrichtung (100, 200) Folgendes umfasst:
ein Basisgehäuse (210);
mindestens einen Resonator (230, 240), der ein Resonatorgehäuse (231, 241) umfasst, das konfiguriert ist, um mit einer Seite des Basisgehäuses (210) gekoppelt zu werden, wobei mindestens eine Spule und mindestens ein Kondensator in dem Resonatorgehäuse (231, 241) enthalten sind; und
eine im Basisgehäuse (210) angeordnete Zuführung (250), die eine Spule und einen mit der Spule in Reihe oder parallel gekoppelten Kondensator umfasst und so konfiguriert ist, dass sie ein elektromagnetisches Feld erzeugt, das mit dem mindestens einen Resonator (230, 240) gekoppelt wird, um drahtlose Energie (161) an die elektronische Vorrichtung (150, 350-1) zu übertragen,
wobei die drahtlose Energieübertragungsvorrichtung (100, 200) **dadurch gekennzeichnet ist, dass**
die Zuführung (250) einen variablen Winkel aufweist, der eine Neigung in Bezug auf den Resonator (230, 240) ermöglicht.

2. Drahtlose Energieübertragungsvorrichtung (100, 200) nach Anspruch 1, wobei der mindestens eine Resonator (230, 240) so konfiguriert ist, dass er abnehmbar mit dem Basisgehäuse (210) gekoppelt ist.

3. Drahtlose Energieübertragungsvorrichtung (100, 200) nach Anspruch 1 oder 2, wobei der mindestens eine Resonator (230, 240) ein ringförmiger Resonator (230, 240) ist, in dem ein hohler Abschnitt ausgebildet ist.

4. Drahtlose Energieübertragungsvorrichtung (100, 200) nach einem der Ansprüche 1 bis 3, wobei der mindestens eine Resonator (230, 240) umfasst:
einen ersten Resonator (230), der ein erstes Resonatorgehäuse (231) umfasst, das so konfiguriert ist, dass es mit einer Seite des Basisgehäuses (210) gekoppelt ist, wobei mindestens eine Spule und mindestens ein Kondensator in dem ersten Resonatorgehäuse (231) enthalten sind, und
einen zweiten Resonator (240), der ein zweites Resonatorgehäuse (241) umfasst, das so konfiguriert ist, dass es mit einer Seite des Basisgehäuses (210) gekoppelt ist, wobei mindestens eine Spule und mindestens ein Kondensator in dem zweiten Resonatorgehäuse (241) enthalten sind.

5. Drahtlose Energieübertragungsvorrichtung (100, 200) nach Anspruch 4, wobei das Basisgehäuse (210) eine äußere Umfangskante (214), die einem hohlen Abschnitt des ersten Resonatorgehäuses (231) entspricht, wenn das erste Resonatorgehäuse (231) aufgenommen wird, und einen gestuften Abschnitt (213) umfasst, der zum Unterstützen des ersten Resonatorgehäuses (231) konfiguriert ist.

6. Drahtlose Energieübertragungsvorrichtung (100, 200) nach Anspruch 4, wobei in einer oberen Fläche (211) des Basisgehäuses (210) eine Nut (212) ausgebildet ist, an die das zweite Resonatorgehäuse (241) konfiguriert ist, um gekoppelt zu werden.

7. Drahtlose Energieübertragungsvorrichtung (100, 200) nach Anspruch 4, wobei das erste Resonatorgehäuse (231) so konfiguriert ist, dass es mit dem Basisgehäuse (210) in einer horizontalen Richtung zum Boden gekoppelt ist, und
wobei das zweite Resonatorgehäuse (241) konfiguriert ist, um mit dem Basisgehäuse (210) in einer Richtung senkrecht zum ersten Resonatorgehäuse (231) gekoppelt zu werden.

8. Drahtlose Energieübertragungsvorrichtung (100, 200) nach Anspruch 4, wobei die Zuführung (250) umfasst:
eine erste Zuführung (251), die so konfiguriert ist, dass sie ein elektromagnetisches Feld in dem ersten Resonator (230) erzeugt; und
eine zweite Zuführung (252), die so konfiguriert ist, dass sie ein elektromagnetisches Feld in dem zweiten Resonator (240) erzeugt.

9. Drahtlose Energieübertragungsvorrichtung (100, 200) nach einem der Ansprüche 1 bis 8, wobei die Zuführung (250) einen Winkel aufweist, der sich in Bezug auf den Resonator (230, 240) in Abhängigkeit von den Haltungsinformationen einer elektronischen Vorrichtung (150, 350-1), die um die drahtlose Energieübertragungsvorrichtung (100, 200) herum angeordnet ist, ändert.

10. Drahtlose Energieübertragungsvorrichtung (100, 200) nach einem der Ansprüche 1 bis 3, wobei mindestens ein Gebläse (270) in einem Innenraum (245) des Basisgehäuses (210) untergebracht ist und mindestens ein Auslassanschluss (215), durch den von dem Gebläse (270) abgegebene Kühlluft abgegeben wird, in der äußeren Umfangskante (214) des Basisgehäuses (210) ausgebildet ist, und
wobei das Resonatorgehäuse (231, 241) einen Einlassanschluss (234) aufweist, der konfiguriert ist, um von dem Gebläse (270) abgegebene Kühlluft anzusaugen, und einen Ausstoßanschluss (233), der konfiguriert ist, um von dem Einlassanschluss (234) eingeführte und in das Resonatorgehäuse (231, 241) strömende Abluft abzugeben.

11. Drahtlose Energieübertragungsvorrichtung (100, 200) nach einem der Ansprüche 1 bis 10, ferner umfassend mindestens einen Sensor (107, 157), der zum Messen einer Übertragungsspannung oder eines Übertragungsstroms des mindestens einen Resonators (230, 240) konfiguriert ist.

12. Drahtlose Energieübertragungsvorrichtung (100, 200) nach einem der Ansprüche 1 bis 11, umfassend einen Prozessor (102, 152, 820), der konfiguriert ist, um zu steuern, ob die Zuführung (250) den ersten Resonator (230) oder den zweiten Resonator (240) mit Energie (161) versorgt, in Abhängigkeit von Ladezustandsüberwachungsinformationen einer elektronischen Vorrichtung (150, 350-1) um die drahtlose Energieübertragungsvorrichtung (100, 200) herum und von Haltungsinformationen der elektronischen Vorrichtung (150, 350-1).

13. Drahtlose Energieübertragungsvorrichtung (100, 200) nach Anspruch 12, wobei der Prozessor (102, 152, 820) konfiguriert ist, um die Energieübertragungsschaltung (109) zu steuern, um die Effizienz der an die elektronische Vorrichtung (150, 350-1) übertragenen Energie (161) einzustellen.

14. Drahtlose Energieübertragungsvorrichtung (100, 200) nach Anspruch 12, wobei der Prozessor (102, 152, 820) konfiguriert ist, um, wenn mehrere elektronische Vorrichtungen (150, 350-1) um die drahtlose Energieübertragungsvorrichtung (100, 200) herum angeordnet sind, die Energieübertragungsschaltung (109) zu steuern, um Energie (161) entsprechend einer Ladepriorität der mehreren elektronischen Vorrichtungen (150, 350-1) zu übertragen.

15. Drahtlose Energieübertragungsvorrichtung nach Anspruch 12, wobei die Ladezustandsüberwachungsinformationen mindestens eines von Spannungsinformationen, Strominformationen, einem Ladezustand, SOC, oder einem Gesundheitszustand, SOH, umfassen.

## Revendications

1. Dispositif de transmission d'énergie sans fil (100, 200) permettant d'alimenter sans fil en énergie (161) au moins un dispositif électronique (150, 350-1), le dispositif de transmission d'énergie sans fil (100, 200) comprenant :
un boîtier de base (210) ;
au moins un résonateur (230, 240) comprenant un boîtier de résonateur (231, 241) configuré pour être couplé à un côté du boîtier de base (210), au moins une bobine et au moins un condensateur étant compris dans le boîtier de résonateur (231, 241) ; et
un dispositif d'alimentation (250) disposé dans le boîtier de base (210), comprenant une bobine et un condensateur couplé à la bobine en série ou en parallèle, et configuré pour générer un champ électromagnétique à coupler à l'au moins un résonateur (230, 240) pour transmettre une énergie sans fil (161) au dispositif électronique (150, 350-1),
le dispositif de transmission d'énergie sans fil (100,200) étant **caractérisé en ce que**
le dispositif d'alimentation (250) a un angle variable permettant l'inclinaison par rapport au résonateur (230, 240).

2. Dispositif de transmission d'énergie sans fil (100, 200) de la revendication 1, dans lequel l'au moins un résonateur (230, 240) est configuré pour être couplé de manière amovible au boîtier de base (210).

3. Dispositif de transmission d'énergie sans fil (100, 200) de la revendication 1 ou 2, dans lequel l'au moins un résonateur (230, 240) est un résonateur (230, 240) en forme d'anneau dans lequel une partie creuse est formée.

4. Dispositif de transmission d'énergie sans fil (100, 200) de l'une quelconque des revendications 1 à 3, dans lequel l'au moins un résonateur (230, 240) comprend :
un premier résonateur (230) comprenant un premier boîtier de résonateur (231) configuré pour être couplé à un côté du boîtier de base (210), au moins une bobine et au moins un condensateur étant compris dans le premier boîtier de résonateur (231), et
un second résonateur (240) comprenant un second boîtier de résonateur (241) configuré pour être couplé à un côté du boîtier de base (210), au moins une bobine et au moins un condensateur étant compris dans le second boîtier de résonateur (241).

5. Dispositif de transmission d'énergie sans fil (100, 200) de la revendication 4, dans lequel le boîtier de base (210) comprend un bord circonférentiel extérieur (214) correspondant à une partie creuse du premier boîtier de résonateur (231), lorsque le premier boîtier de résonateur (231) est assis, et une partie étagée (213) configurée pour prendre en charge le premier boîtier de résonateur (231).

6. Dispositif de transmission d'énergie sans fil (100, 200) de la revendication 4, dans lequel une rainure (212), à laquelle le second boîtier de résonateur (241) est configuré pour être couplé, est formée dans une surface supérieure (211) du boîtier de base (210).

7. Dispositif de transmission d'énergie sans fil (100, 200) de la revendication 4, dans lequel le premier boîtier de résonateur (231) est configuré pour être couplé au boîtier de base (210) dans une direction horizontale par rapport au sol, et
dans lequel le second boîtier de résonateur (241) est configuré pour être couplé au boîtier de base (210) dans une direction perpendiculaire au premier boîtier de résonateur (231).

8. Dispositif de transmission d'énergie sans fil (100, 200) de la revendication 4, dans lequel le dispositif d'alimentation (250) comprend :
un premier dispositif d'alimentation (251) configuré pour générer un champ électromagnétique dans le premier résonateur (230) ; et
un second dispositif d'alimentation (252) configuré pour générer un champ électromagnétique dans le second résonateur (240).

9. Dispositif de transmission d'énergie sans fil (100, 200) de l'une quelconque des revendications 1 à 8, dans lequel le dispositif d'alimentation (250) présente un angle variant par rapport au résonateur (230, 240) en fonction des informations de posture d'un dispositif électronique (150, 350-1) placé autour du dispositif de transmission d'énergie sans fil (100, 200).

10. Dispositif de transmission d'énergie sans fil (100, 200) de l'une quelconque des revendications 1 à 3, dans lequel au moins un ventilateur (270) est logé dans un espace intérieur (245) du boîtier de base (210), et au moins un orifice de sortie (215) à travers lequel l'air froid évacué par le ventilateur (270) est déchargé est formé dans le bord circonférentiel extérieur (214) du boîtier de base (210), et
dans lequel le boîtier de résonateur (231, 241) comporte un orifice d'entrée (234) configuré pour aspirer l'air froid évacué par le ventilateur (270), et un orifice d'échappement (233) configuré pour évacuer l'air d'échappement introduit par l'orifice d'entrée (234) et circulant dans le boîtier de résonateur (231, 241).

11. Dispositif de transmission d'énergie sans fil (100, 200) de l'une quelconque des revendications 1 à 10, comprenant en outre au moins un capteur (107, 157) configuré pour mesurer une tension de transmission ou un courant de transmission de l'au moins un résonateur (230, 240).

12. Dispositif de transmission d'énergie sans fil (100, 200) de l'une quelconque des revendications 1 à 11, comprenant un processeur (102, 152, 820) configuré pour commander si le dispositif d'alimentation (250) fournit de l'énergie (161) au premier résonateur (230) ou au second résonateur (240) en fonction des informations de surveillance d'état de charge d'un dispositif électronique (150, 350-1) autour du dispositif de transmission d'énergie sans fil (100, 200) et des informations de posture du dispositif électronique (150, 350-1).

13. Dispositif de transmission d'énergie sans fil (100, 200) de la revendication 12, dans lequel le processeur (102, 152, 820) est configuré pour commander le circuit de transmission d'énergie (109) afin d'ajuster l'efficacité de l'énergie (161) transmise au dispositif électronique (150, 350-1).

14. Dispositif de transmission d'énergie sans fil (100, 200) de la revendication 12, dans lequel le processeur (102, 152, 820) est configuré pour commander, lorsque plusieurs dispositifs électroniques (150, 350-1) sont placés autour du dispositif de transmission d'énergie sans fil (100, 200), le circuit de transmission d'énergie (109) pour transmettre l'énergie (161) en fonction d'une priorité de charge des plusieurs dispositifs électroniques (150, 350-1).

15. Dispositif de transmission d'énergie sans fil de la revendication 12, dans lequel les informations de surveillance d'état de charge comprennent au moins un des informations de tension, des informations de courant, d'un état de charge, SOC, ou d'un état de santé, SOH.
